# FASCICULE DE BREVET EUROPEEN

(11) **EP 0 943 099 B1**
(45) Date de publication et mention de la délivrance du brevet: **08.05.2002**
(21) Numéro de dépôt: 97948954.9
(22) Date de dépôt: 28.11.1997
(51) Int. Cl.: G01R 31/02

(54) **ELEMENT DE CONDUITE DE PROTECTION DE CABLE GAINE POUR CONTROLER L'INTEGRITE DE LA GAINE**
ELEMENT EINES KABELSCHUTZROHRES ZUR ÜBERPRÜFUNG DER UNVERSEHRTHEIT DES KABELSCHUTZSCHLAUCHES
PROTECTIVE PIPE ELEMENT FOR SHEATHED CABLE FOR VERIFYING THE INTEGRITY OF THE SHEATH

(30) Priorité: 04.12.1996 FR 9614861
(43) Date de publication de la demande: 22.09.1999
(73) Titulaire: SAT (Société Anonyme de Télécommunications), 75116 Paris (FR)
(72) Inventeur: ARGAUT, Pierre, F-75626 Paris Cedex 13 (FR); GOFFLO, Pierre, F-75626 Paris Cedex 13 (FR)
(74) Mandataire: Bloch, Gérard
(86) Numéro de dépôt international: FR9702152
(87) Numéro de publication internationale: WO9825151

(56) Documents cités:
- WO-A-90/05311

## Description

Lorsqu'on installe un câble électrique ou optique, on le fait en général passer dans une conduite destinée à assurer sa protection mécanique. Ceci est particulièrement utile dans le cas d'un câble souterrain, non visible et donc susceptible d'être endommagé.

Les câbles dont il s'agit comportent généralement des conducteurs ou des conduits disposés dans une gaine commune qui assure à l'ensemble une protection mécanique. Ils peuvent comporter un élément de renfort mécanique qui évite tout allongement excessif qui risquerait de rompre les conducteurs lors du tirage de câble dans la conduite.

Pour réduire le coût tout en facilitant la manipulation, la conduite est souvent en matière plastique.

Lorsqu'un câble souterrain vient d'être installé, on procède à un essai d'isolement entre ses éléments conducteurs et la terre, afin de vérifier que la gaine n'a pas été détérioriée lors des opérations d'installation. En effet, une gaine blessée laisse s'infiltrer l'humidité qui peut ensuite détériorer le câble.

Pour vérifier cet isolement, on applique une tension entre les éléments conducteurs et la terre et, si l'isolement qu'on mesure entre les deux n'est pas parfait, c'est qu'il y a des fuites électriques et donc un risque de passage d'humidité.

Quand on place le câble gainé dans une conduite, on se heurte à la difficulté de la présence de cette conduite, introduisant un isolement supplémentaire qui interdit une mesure correcte de l'isolement de la gaine du câble.

Il faut cependant détecter dès l'origine les défauts de gaine afin de. garantir la fiabilité voulue pour le câble.

Le problème qui se pose est de vérifier l'intégrité de la gaine d'un câble installé dans une conduite de protection et de mesurer des fuites électriques entre la gaine de protection et tout conducteur électrique interne, à savoir un élément électrique, quand il y en a, ou encore un élément de renfort mécanique, quand il y en a.

Pour résoudre ce problème, l'invention propose un élément d'une conduite destinée à recevoir sur sa paroi interne un câble électrique ou optique gainé pour le protéger, l'élément de conduite étant agencé pour être raccordé à ses deux extrémités à deux portions de conduite de protection et caractérisé par le fait qu'il est au moins en partie conducteur et que ses parois interne et externe sont reliées électriquement pour en faire un élément de contrôle de l'intégrité de la gaine du câble.

Ainsi, le câble se trouve mis au potentiel de l'extérieur de l'élément de conduite et est donc électriquement accessible pour permettre un test d'isolement de l'extérieur du câble, a priori de sa gaine isolante.

Par WO 90/05 311, il est connu un élément de test destiné à recevoir sur sa paroi interne un câble (électrique). Mais ce document enseigne une conduite de test qui n'est que provisoire ; les parois internes et externes ne sont reliées électriquement, que pour le test d'intégrité.

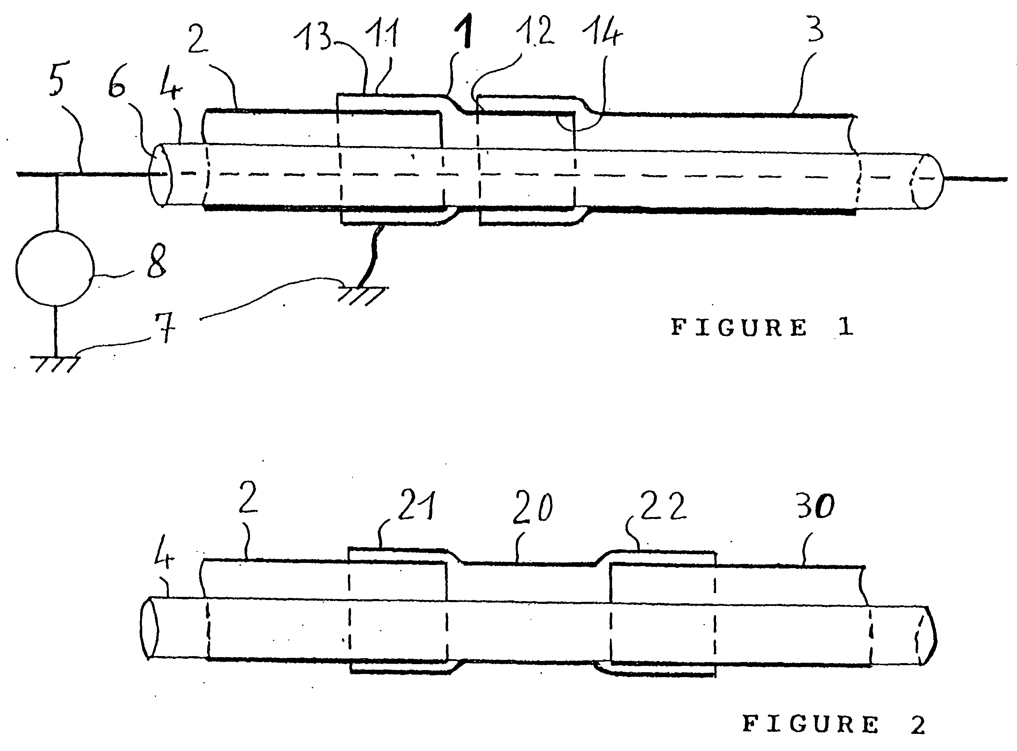

L'invention sera mieux comprise à l'aide de la description suivante de deux variantes de réalisation préférées de l'élément de conduite de l'invention, en référence aux figures 1 et 2 du dessin annexé, qui représentent respectivement, en coupe axiale, les deux variantes.

Sur la figure 1, l'élément de conduite, portant la référence 1, assure ici l'aboutement de deux portions 2, 3 d'une conduite classique en matériau plastique dans laquelle, pour le protéger, a été passé un câble 4 comportant un conducteur électrique 5 entouré d'une gaine isolante 6. L'ensemble est ici placé en terre 7 et la liaison y aboutissant sur la figure 1 ne fait qu'illustrer ce fait.

L'élément 1 est ici de forme tubulaire, avec deux extrémités 11, 12 de raccordement, par emboîtement, recevant respectivement avec coulissement les extrémités des deux portions de conduite de protection 2 et 3, de façon à maintenir l'étanchéité de la conduite, souhaitée dans cet exemple. Le jeu radial entre les pièces 1, 2 et 1, 3 a volontairement été exagéré sur le dessin, dans un but de clarté. L'extrémité 11, femelle, reçoit intérieurement une extrémité de la portion de conduite 2, tandis que l'extrémité de la portion de conduite 3 reçoit intérieurement l'extrémité 12, mâle. Il peut être prévu un collage d'étanchéité ou encore une adaptation de forme par thermoformage. L'élément 1 comporte une paroi interne 14 et une paroi externe 13 reliées électriquement pour en faire un dispositif de test d'isolement du câble 4, plus précisément de sa gaine 6. L'extérieur de la gaine 6 est en effet en contact avec la paroi interne 14 qui est au même potentiel que la paroi externe 13, c'est-à-dire celui de la terre 7.

Dans cet exemple, la totalité de l'élément 1 est à cet effet un manchon en matériau conducteur à base de matière plastique dopée au carbone.

La référence 8 symbolise une source de potentiel alternatif de test reliant le conducteur 5 à la terre 7. En cas de défaut de la gaine 6, un courant de fuite peut ainsi traverser plus facilement la gaine pour circuler entre le conducteur 5 et la terre 7 et être détecté au niveau de la source 8. Ainsi, l'élément 1 est un dispositif de test coopérant avec la source de test 8.

Si le défaut est situé dans une zone de la gaine 6 qui n'est pas en contact avec la paroi interne 14, il pourra être détecté, dans la mesure où il est suffisamment proche de la zone de contact de la paroi interne 14 pour qu'un courant de fuite détectable puisse cheminer, dans ou sur la gaine 6 ou le long de la paroi interne de la portion de conduite 2 ou 3, entre la zone de contact ci-dessus, à la terre, et ce défaut. A cette fin, afin de disposer, à distances régulières, du potentiel de terre, la totalité de la conduite est constituée d'une alternance de portions de conduite comme 2 et 3 et d'éléments comme 1. On peut ainsi contrôler tout câble, électrique ou optique, comportant un conducteur électrique.

Afin de rendre le dispositif de contrôle encore plus efficace, on peut vouloir disposer d'une gaine de câble plus ou moins conductrice en surface, par exemple par incorporation de noir de carbone dans la matière d'extrusion de la gaine.

On peut vouloir encore enduire la gaine de câble et/ou la paroi interne de la conduite d'un revêtement au-noir de carbone ou d'une graisse conductrice plus ou moins conductrice.

On conçoit que l'aboutement des portions de conduite 2, 3 par l'élément 1 pourrait être réalisé de diverses autres manières, par exemple par des butées radiales.

On comprendra que, l'élément de conduite de l'invention ayant pour fonction d'assurer une continuité électrique entre sa paroi interne et sa paroi externe, cette fonction est commodément réalisée lorsque, comme dans l'exemple ci-dessus, l'élément de conduite a la constitution mécanique d'une conduite et peut ainsi s'insérer entre deux portions de conduite. Cependant, l'élément de conduite de l'invention peut ne pas avoir une telle fonction mécanique et par exemple se présenter sous la forme d'une simple languette conductrice, destinée à traverser, avec ou sans étanchéité, la paroi de la conduite. On peut songer par exemple à une feuille mince ou à un voile souple conducteur interposé entre les extrémités complémentaires des portions de conduite 2 et 3, alors emboîtées directement, feuille ou voile débordant à l'intérieur et l'extérieur des portions de conduite 2, 3.

La variante de la figure 2 ne diffère de celle de la figure 1 que par le fait que l'élément de conduite 20 comporte deux extrémités tubulaires identiques de raccordement 21, 22, femelles, l'extrémité de la portion de conduite 30, homologue de la portion de conduite 3, étant alors semblable à celle de la portion de conduite 2. Les autres éléments, inchangés, conservent leurs références.

## Revendications

1. Elément d'une conduite destinée à recevoir sur sa paroi interne (14) un câble électrique ou optique gainé (4) pour le protéger, l'élément de conduite étant agencé pour être raccordé à ses deux extrémités (11, 12) à deux portions de conduite de protection (2, 3) et, **caractérisé par le fait qu'**il est au moins en partie conducteur et que ses parois interne (14) et externe (13) sont reliées électriquement pour en faire un élément de contrôle de l'intégrité de la gaine (6) du câble (4).

2. Elément de conduite selon la revendication 1, comprenant une extrémité de raccordement femelle (11,21).

3. Elément de conduite selon l'une des revendications 1 et 2, comprenant une extrémité de raccordement mâle (12).

4. Elément de conduite selon l'une des revendications 1 à 3, en matériau conducteur.

5. Elément de conduite selon la revendication 1, constitué d'un voile souple.

## Claims

1. Element of a pipe which is intended to receive on its internal wall (14) a sheathed electrical or optical cable (4) in order to protect it, the pipe element being arranged to be connected at its two ends (11, 12) to two protective pipe portions (2, 3) and **characterised by** the fact that it is at least partially conductive and in that its internal (14) and external (13) walls are electrically connected in order to form an element for verifying the integrity of the sheath (6) of the cable (4).

2. Pipe element according to claim 1, comprising a female connecting end (11, 21).

3. Pipe element according to one of claims 1 and 2, comprising a male connecting end (12).

4. Pipe element according to one of claims 1 to 3, formed from conductive material.

5. Pipe element according to claim 1, consisting of a flexible voile.

## Patentansprüche

1. Element einer Rohrleitung, die dazu dient, auf ihrer Innenwand (14) ein elektrisches oder optisches ummanteltes Kabel (4) zu dessen Schutz aufzunehmen, wobei das Rohrleitungselement derart ausgebildet ist, daß es an seinen beiden Enden (11, 12) mit zwei Schutzrohrleitungsteilen (2, 3) verbindbar ist, **dadurch gekennzeichnet, daß** es wenigstens teilweise leitfähig ist und daß seine Innenwand (14) und seine Außenwand (13) elektrisch verbunden sind, um dieses zu einem Element zur Kontrolle der Unversehrtheit des Mantels (6) des Kabels (4) zu machen.

2. Rohrleitungselement nach Anspruch 1, wobei es ein Aufnahme-Verbindungsende (11, 21) aufweist.

3. Rohrleitungselement nach Anspruch 1 oder 2, wobei es ein Einsteck-Verbindungsende (12) aufweist.

4. Rohrleitungselement nach einem der Ansprüche 1 bis 3, bestehend aus leitfähigem Material.

5. Rohrleitungselement nach Anspruch 1, bestehend aus einer flexiblen Hülle.
